**Europäisches Patentamt**

**European Patent Office**

**Office européen des brevets**

(19)

(11) Veröffentlichungsnummer : **0 458 931 B1**

(12) # EUROPÄISCHE PATENTSCHRIFT

(45) Veröffentlichungstag der Patentschrift :
**27.04.94 Patentblatt 94/17**

(51) Int. Cl.$^5$ : **G01D 5/24,** G01L 9/12,
G01L 9/00, G01R 27/26

(21) Anmeldenummer : **91900801.1**

(22) Anmeldetag : **11.12.90**

(86) Internationale Anmeldenummer :
**PCT/EP90/02124**

(87) Internationale Veröffentlichungsnummer :
**WO 91/09278 27.06.91 Gazette 91/14**

(54) **ANORDNUNG ZUR VERARBEITUNG VON SENSORSIGNALEN.**

(30) Priorität : **20.12.89 DE 3942159**

(43) Veröffentlichungstag der Anmeldung :
**04.12.91 Patentblatt 91/49**

(45) Bekanntmachung des Hinweises auf die
Patenterteilung :
**27.04.94 Patentblatt 94/17**

(84) Benannte Vertragsstaaten :
**BE CH DE DK ES FR GB IT LI NL SE**

(56) Entgegenhaltungen :
**US-A- 4 039 940**
**IEEE Transactions on Instrumentation and**
**Measurement, vol. im-36, no. 4, Dezember**
**1987, New York, US, Seiten 873-878; Matsu-**
**moto et al.: "A switched-capacitor charge-**
**balancing A/D converter and its application to**
**capacitance measurement"**

(56) Entgegenhaltungen :
**Technisches Messen ATM, vol. 54, no. 3, 1987,**
**München, DE, Seiten 111-115; J. Knapp:**
**"Einfacher Anpasser für kapazitive Senso-**
**ren"**

(73) Patentinhaber : **ENDRESS U. HAUSER GMBH**
**U. CO.**
**Hauptstr. 1, Postfach 1261**
**D-79689 Maulburg (DE)**

(72) Erfinder : **SCHNEIDER, Georg**
**Talstrasse 55**
**D-7860 Schopfheim-Langenau (DE)**
Erfinder : **WAGNER, Richard**
**Hans-Thoma-Strasse 9**
**D-7864 Maulburg (DE)**

(74) Vertreter : **Morstadt, Volker, Dipl.-Ing. c/o**
**Endress + Hauser Flowtec AG**
**Kägenstrasse 7 Postfach 435**
**CH-4153 Reinach BL 1 (CH)**

EP 0 458 931 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 458 931 B1

## Beschreibung

Die Erfindung betrifft eine Anordnung zur Verarbeitung von Sensorsignalen, die von einem kapazitiven Sensor geliefert werden.

In der Zeitschrift "IEEE Transactions on Instrumentation and Measurement", Band 4, Dez. 1987, Seiten 873 bis 878, ist eine Anordnung zur Verarbeitung von Sensorsignalen beschrieben, die von einem kapazitiven Sensor geliefert werden, der einen Meßkondensator mit von einer zu erfassenden physikalischen Meßgröße beeinflußbarer Meßkapazität und mindestens einen Referenzkondensator mit in anderer Weise beeinflußbarer Referenzkapazität enthält und einen von diesen beiden abhängigen Meßeffekt liefert, mit einer nach dem Prinzip des quantisierten Ladungstransports mittels Schalter-Kondensator-Strukturen und Ladungsbalance mindestens im zeitlichen Mittel arbeitenden Signalverarbeitungsschaltung, die die den Meßeffekt darstellenden Sensorsignale empfängt und ein ihm entsprechendes Ausgangssignal liefert.

In der US-A-4039940 ist ferner eine mit der Anordnung nach der eben zitierten Zeitschrift vergleichbare Anordnung zur Verarbeitung von Sensorsignalen, die von einem kapazitiven Sensor geliefert werden, beschrieben. Dabei sind einerseits die einen Elektroden der Kondensatoren mit Massepotential verbunden und andererseits ist ein als Schwellwert-Schalter betriebener, kein analoges, sondern ein digitales Ausgangssignal liefernder Operationsverstärker offenbart, dessen einer Eingang auf einer den Schwellwert vorgebenden, festen Spannung liegt, während der andere Eingang mit den nicht mit einem festen Potential verbundenen Elektroden der Kondensatoren verbindbar ist.

Eine Signalverarbeitung nach dem Prinzip des quantisierten Ladungstransports mittels Schalter-Kondensator-Strukturen und Ladungsbalance ergibt die Vorteile, daß Offsetspannungen der verwendeten Operationsverstärker keinen Einfluß auf das Ausgangssignal haben, daß die Schaltungen in CMOS-Technologie vollständig integrierbar sind und daß keine genaue und langzeitstabile Referenzspannung erforderlich ist. Ferner können aus den Takten, mit denen die Schalter-Kondensator-Strukturen zur Durchführung der Ladungstransporte gesteuert werden, zwei Taktsignale abgeleitet werden, deren Frequenz- oder Impulszahlverhältnis direkt dem Meßeffekt proportional ist, so daß das Meßergebnis in digitaler Form vorliegt. Bei der eingangs zuerst erwähnten Schaltung ist jeweils eine Elektrode der Kondensatoren des Sensors bzw. eine diesen Kondensatoren gemeinsame Elektrode durch die zur Signalverarbeitungsschaltung führende Signalleitung mit einem Eingang eines Operationsverstärkers verbunden, dessen anderer Eingang auf einem festen Bezugspotential, beispielsweise dem Massepotential liegt. An die anderen Elektroden der Sensor-Kondensatoren werden durch periodisch betätigte Schalter die Spannungen angelegt, die zur Umladung für die Erzeugung der zu transportierenden Ladungspakete erforderlich sind.

Ein Nachteil der eingangs zuerst genannten Anordnung besteht darin, daß alle Elektroden der Sensor-Kondensatoren aktiv sind. Daher kann ihre Funktion gestört werden, wenn auf die mit der Signalleitung verbundenen Elektroden von externen elektrischen Feldern Ladungen eingekoppelt werden. Die zu deren Unterdrückung erforderlichen Abschirmmaßnahmen schränken die Aufbau- und Einsatzmöglichkeiten ein und sind daher nicht immer anwendbar.

Der Erfindung liegt als Aufgabe die Schaffung einer Anordnung zugrunde, die unter Beibehaltung der Vorteile der Signalverarbeitung nach dem Prinzip des quantisierten Ladungstransports mittels Schalter-Kondensator-Strukturen und Ladungsbalance eine einseitige feste Anbindung der Sensor-Kondensatoren nicht nur an Massepotential, sondern an ein beliebiges Potential ermöglicht.

Diese Aufgabe wird erfindungsgemäß gelöst durch eine Anordnung zur Verarbeitung von Sensorsignalen, die von einem kapazitiven Sensor geliefert werden, der einen Meßkondensator mit von einer zu erfassenden physikalischen Meßgröße beeinflußbarer Meßkapazität und mindestens einen Referenzkondensator mit in anderer Weise beeinflußbarer Referenzkapazität enthält und einen von diesen beiden abhängigen Meßeffekt liefert, mit einer nach dem Prinzip des quantisierten Ladungstransports mittels Schalter-Kondensator-Strukturen und Ladungsbalance mindestens im zeitlichen Mittel arbeitenden Signalverarbeitungsschaltung, die die den Meßeffekt darstellenden Sensorsignale empfängt und ein ihm entsprechendes Ausgangssignal liefert, von welchen Kondensatoren erste Elektroden auf einem festen Potential liegen und zweite Elektroden zur Durchführung des Ladungstransports mit dem ersten Eingang eines Eingangsoperationsverstärkers verbindbar sind, dessen zweiter Eingang auf einem Bezugspotential liegt, das zwecks der zur Bildung der transportierten Ladungspakete erforderlichen Umladung der Kondensatoren umgeschaltet wird.

Bei dieser Anordnung wird die Tatsache ausgenutzt, daß die beiden Eingänge eines Operationsverstärkers bis auf die Offsetspannung virtuell auf dem gleichen Potential liegen. Durch die Umschaltung des Bezugspotentials des Eingangsoperationsverstärkers wird daher auch das Potential der jeweils mit dem anderen Eingang verbundenen Kondensatorelektrode in der gleichen Weise geändert. Auf diese Weise können die zur Umladung der Sensor-Kondensatoren erforderlichen Spannungsänderungen an den mit der Signalleitung verbundenen Kondensatorelektroden vorgenommen werden, so daß nur diese Elektroden aktiv sind. Die anderen

2

EP 0 458 931 B1

Elektroden, die stets inaktiv sind, können dagegen auf ein beliebiges Potential gelegt werden, das beispielsweise das Gehäusepotential eines entsprechenden Sensors sein kann. Für dieses Potential besteht nur die Bedingung, daß es im Kurzzeitbereich relativ zu dem für die Signalverarbeitung verwendeten Versorgungssignal stabil sein muß.

Vorteilhafte Ausgestaltungen und Weiterbildungen der Erfindung sind in den abhängigen Ansprüchen gekennzeichnet.

Die Erfindung wird anhand der Beschreibung von Ausführungsbeispielen, die in den Figuren der Zeichnung dargestellt sind, näher erläutert.

Fig. 1 zeigt ein Prinzipschema zur Erläuterung des der Erfindung zugrundeliegenden Problems,

Fig. 2 zeigt eine Schnittansicht eines kapazitiven Sensors,

Fig. 3 zeigt das Schaltbild eines ersten Ausführungsbeispiels einer mit quantisiertem Ladungstransport mittels Schalter-Kondensator-Strukturen und Ladungsbalance arbeitenden Signalverarbeitungsschaltung, deren Ausgangssignal eine Frequenz ist,

Fig. 4 zeigt Zeitdiagramme von Signalen, die sich bei Betrieb der Signalverarbeitungsschaltung von Fig. 3 ergeben,

Fig 5. zeigt das Schaltbild eines zweiten Ausführungsbeispiels einer mit quantisiertem Ladungstransport mittels Schalter-Kondensator-Strukturen und Ladungsbalance arbeitenden und ein analoges Ausgangssignal liefernden Signalverarbeitungsschaltung, und

Fig. 6 zeigt Zeitdiagramme von Signalen, die sich bei Betrieb der Signalverarbeitungsschaltung von Fig. 5 ergeben.

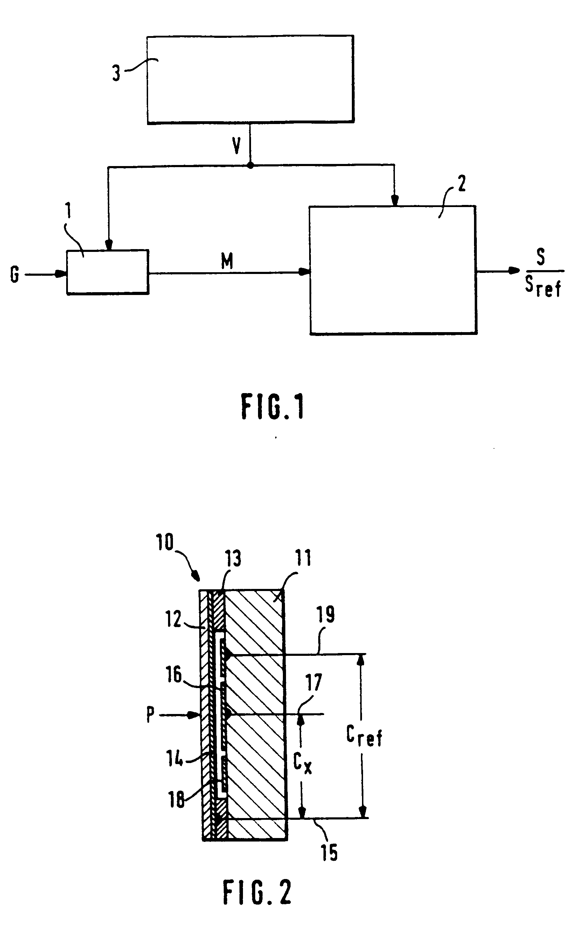

Zum besseren Verständnis ist in Fig. 1 das Prinzip der Verarbeitung von Sensorsignalen dargestellt, auf dem die Erfindung beruht. Fig. 1 zeigt einen kapazitiven Sensor 1, mit dessen Hilfe eine physikalische Größe G gemessen werden soll, und eine mit dem Sensor 1 verbundene Signalverarbeitungsschaltung 2. Der Sensor 1 enthält einen Meßkondensator, dessen Kapazität in Abhängigkeit von der zu messenden physikalischen Größe veränderlich ist. Eine Versorgungssignalquelle 3 liefert zu dem Sensor 1 ein Versorgungssignal V, das es ermöglicht, die Änderung der Meßkapazität in ein elektrisches Sensorsignal umzuwandeln, das der Signalverarbeitungsschaltung 2 zugeführt wird und das den Meßeffekt M ausdrückt, der den Zusammenhang zwischen der zu messenden physikalischen Größe G und der Meßkepazität darstellt. Die Signalverarbeitungsschaltung 2 wandelt das Sensorsignal in ein Ausgangssignal S einer gewünschten Form um, das vorzugsweise auf ein Referenzsignal $S_{ref}$ bezogen ist. Je nach der Ausbildung der Signalverarbeitungsschaltung 2 kann das Ausgangssignal S beipsielsweise ein Analogsignal, ein digitales Signal oder eine Frequenz sein.

Wenn beispielsweise angenommen wird, daß die zu messende physikalische Größe G ein Druck ist, kann für den Sensor 1 der in Fig. 2 in Schnittansicht dargestellte kapazitive Drucksensor 10 verwendet werden. Der Drucksensor 10 hat einen Grundkörper 11 und eine Membran 12, die am Umfang durch einen Abstandsring 13 miteinander verbunden sind. Die dem Grundkörper 11 zugewandte Fläche der Membran 12 ist mit einer Metallisierung 14 versehen, die mit einem durch den Abstandsring 13 und durch den Grundkörper 11 hindurchgeführten Anschlußleiter 15 verbunden ist. Die der Membran 12 zugewandte Fläche des Grundkörpers 11 trägt eine zentrale kreisrunde Metallisierung 16, die mit einem durch den Grundkörper 11 hindurchgeführten Anschlußleiter 17 verbunden ist, und eine die Metallisierung 16 umgebende ringförmige Metallisierung 18, die mit einem durch den Grundkörper 11 hindurchgeführten Anschlußleiter 19 verbunden ist.

Wenn auf die Außenfläche der Membran 12 ein Druck P einwirkt, wird die Membran verformt, so daß sich der Abstand zwischen dem mittleren Bereich der Metallisierung 14 und der gegenüberliegenden zentralen Metallisierung 16 in Abhängigkeit von diesem Druck ändert. Die beiden Metallisierungen 14 und 16 bilden daher die Elektroden eines Meßkondensators, dessen Kapazität $C_x$ vom Druck P abhängt und zwischen den Anschlußleitern 15 und 17 gemessen werden kann. Dagegen bleibt der Abstand zwischen dem Randbereich der Metallisierung 14 und der gegenüberliegenden ringförmigen Elektrode 18 bei der druckabhängigen Verformung der Membran 12 im wesentlichen unverändert, da dieser Abstand durch den Abstandsring 13 festgelegt ist. Die beiden Metallisierungen 14 und 18 bilden daher die Elektroden eines Referenzkondensators, dessen Kapazität $C_{ref}$ vom Druck P unabhängig ist und zwischen den Anschlußleitern 15 und 19 gemessen werden kann.

Der vom Druck abhängige Meßeffekt M, der in der Signalverarbeitungsschaltung 2 zur Erzeugung des Ausgangssignals $S/S_{ref}$ verwendet wird, ist bei einem solchen kapazitiven Drucksensor also die Änderung der Meßkapazität $C_x$ relativ zur Referenzkapazität $C_{ref}$. Der Meßeffekt kann, je nach dem Anwendungsfall, unterschiedlich dargestellt werden. Beispielsweise kann der Meßeffekt $M_1$ dem Kapazitätsverhältnis $C_x/C_{ref}$ zwischen der Meßkapazität und der Referenzkapazität entsprechen, doch wird vorzugsweise das Kapazitätsverhältnis $(C_x - C_{ref})/C_{ref}$ verwendet, weil man durch die Differenzbildung größere relative Änderungen erhält. Eine weitere Möglichkeit wäre das Kapazitätsverhältnis $(C_x - C_{ref})/C_x$. Natürlich könnte auch die druckabhängige Meßkapazität $C_x$ allein als Meßeffekt verwendet werden, doch ergibt die Quotientenbildung den Vorteil, daß der Meßeffekt von störenden Einwirkungen, die sich auf die beiden Kapazitäten $C_x$ und $C_{ref}$ in gleicher Weise auswirken, weitgehend unbeeinflußt bleibt.

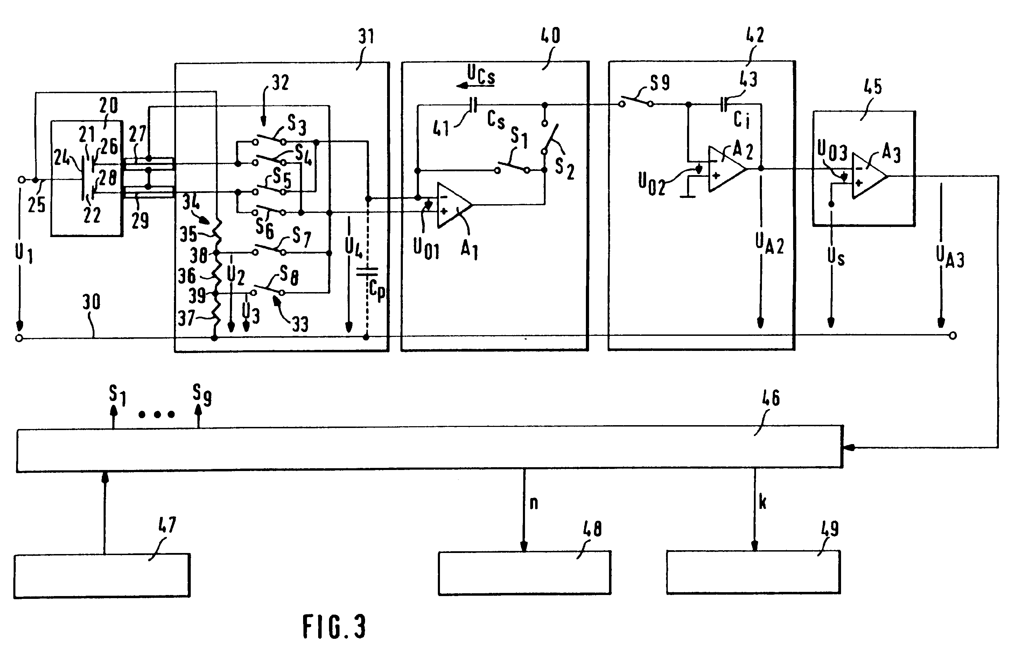

Fig. 3 zeigt ein Ausführungsbeispiel der Signalverarbeitungsschaltung 2 von Fig. 1 für die Signalaufbereitung des von einem kapazitiven Sensor 20 gelieferten Sensorsignals. Der Sensor 20 enthält einen Meßkondensator 21 der Kapazität $C_x$ und einen Referenzkondensator 22 der Kapazität $C_{ref}$. Eine Elektrode 24 ist dem Meßkondensator 21 und dem Referenzkondensator 22 gemeinsam. Der Meßkondensator 21 ist durch eine mit der gemeinsamen Elektrode 24 zusammenwirkende Elektrode 26 gebildet, und der Referenzkondensator 22 ist durch eine mit der gemeinsamen Elektrode 24 zusammenwirkende Elektrode 28 gebildet. Der kapazitive Sensor 20 kann beispielsweise die in Fig. 2 dargestellte Struktur haben, wobei dann die Elektroden 24, 26, 28 von Fig. 3 den Metallisierungen 14, 16 bzw. 18 von Fig. 2 entsprechen. Der interessierende Meßeffekt M ist das Kapazitätsverhältnis $(C_x - C_{ref})/C_{ref}$.

Die gemeinsame Elektrode 24 ist über ihren Anschlußleiter 25, der dem Anschlußleiter 15 von Fig. 2 entspricht, an ein festes Potential gelegt, das beispielsweise das Gehäusepotential des Sensors 20 sein kann. Der Sensor 20 ist also einseitig potentialgebunden. In Fig. 3 unterscheidet sich das Potential am Anschlußleiter 25 um eine feste Spannung $U_1$ von dem Potential eines Bezugsleiters 30; die Spannung $U_1$ entspricht dem Versorgungssignal V von Fig. 1.

Die Elektroden 26, 28 sind über abgeschirmte Signalleitungen 27, 29, die den Anschlußleitern 17 bzw. 19 von Fig. 2 entsprechen, mit einem Funktionsblock 31 der Signalverarbeitungsschaltung verbunden. Der Funktionsblock 31 enthält zwei Schaltergruppen 32 und 33. Zum Funktionsblock gehört ferner ein Spannungsteiler 34 mit drei in Serie geschalteten Widerständen 35, 36, 37, an den die zwischen dem Anschlußleiter 25 und dem Bezugsleiter 30 bestehende Spannung $U_1$ angelegt ist. Der Spannungsteiler 34 hat einen ersten Abgriff 38 zwischen den Widerständen 35 und 36 und einen zweiten Abgriff 39 zwischen den Widerständen 36 und 37. Wenn am Spannungsteiler 34 die Spannung $U_1$ anliegt, besteht zwischen dem Abgriff 38 und dem Bezugsleiter 30 die Spannung $U_2$ und zwischen dem Abgriff 39 und dem Bezugsleiter 30 die Spannung $U_3$.

Dem Funktionsblock 31 ist ein Zwischenspeicher 40 nachgeschaltet, der einen Operationsverstärker $A_1$, einen Speicherkondensator 41 der Kapazität $C_s$ und zwei Schalter $S_1$ und $S_2$ enthält. Wenn der Schalter $S_1$ geschlossen ist, verbindet er den Ausgang des Operationsverstärkers $A_1$ mit dessen invertierendem Eingang. Wenn der Schalter $S_2$ geschlossen ist, verbindet er den Ausgang des Operationsverstärkers $A_1$ mit der einen Elektrode des Speicherkondensators 41, dessen andere Elektrode mit dem invertierenden Eingang des Operationsverstärkers $A_1$ verbunden ist, so daß dann der Speicherkondensator 41 im Rückkopplungskreis des Operationsverstärkers $A_1$ liegt. Das am nichtinvertierenden Eingang anliegende Bezugspotential des Operationsverstärkers $A_1$ unterscheidet sich von dem Potential des Bezugsleiters 30 durch eine Spannung $U_4$. Das Potential am invertierenden Eingang unterscheidet sich um die Offsetspannung $U_{01}$ des Operationsverstärkers $A_1$ vom Bezugspotential des nichtinvertierenden Eingangs.

Zwischen dem invertierenden Eingang des Operationsverstärkers $A_1$ und dem Bezugsleiter 30 besteht eine parasitäre Kapazität $C_p$, die in Fig. 3 durch ein Kondensatorsymbol dargestellt ist.

Die Schaltergruppe 32 enthält vier Schalter $S_3$, $S_4$, $S_5$, $S_6$. Wenn der Schalter $S_3$ geschlossen ist, verbindet er die Elektrode 26 des Meßkondensators 21 mit dem invertierenden Eingang des Operationsverstärkers $A_1$, und wenn der Schalter $S_4$ geschlossen ist, legt er die Elektrode 26 des Meßkondensa- tors 21 an das Bezugspotential am nichtinvertierenden Eingang des Operationsverstärkers $A_1$. Wenn der Schalter $S_5$ geschlossen ist, verbindet er die Elektrode 28 des Referenzkondensators 22 mit dem invertierenden Eingang des Operationsverstärkers $A_1$, und wenn der Schalter $S_6$ geschlossen ist, legt er die Elektrode 28 des Referenzkondensators 22 an das Bezugspotential am nichtinvertierenden Eingang des Operationsverstärkers $A_1$.

Die Schaltergruppe 33 enthält zwei Schalter $S_7$ und $S_8$. Wenn der Schalter $S_7$ geschlossen ist, verbindet er den nichtinvertierenden Eingang des Operationsverstärkers $A_1$ mit dem Abgriff 38 des Spannungsteilers 34, so daß die am nichtinvertierenden Eingang des Operationsverstärkers $A_1$ anliegende Spannung $U_4$ durch die Spannung $U_2$ gebildet wird. Wenn der Schalter $S_8$ geschlossen ist, verbindet er den nichtinvertierenden Eingang des Operationsverstärkers $A_1$ mit dem Abgriff 39 des Spannungsteilers 34, so daß die am nichtinvertierenden Eingang des Operationsverstärkers $A_1$ anliegende Spannung $U_4$ durch die Spannung $U_3$ gebildet wird.

Dem Zwischenspeicher 40 ist ein Integrator 42 nachgeschaltet. Der Integrator 42 enthält einen Operationsverstärker $A_2$, einen im Rückkopplungskreis des Operationsverstärkers $A_2$ liegenden Integrationskondensator 43 der Kapazität $C_I$ und einen Schalter $S_9$. Wenn der Schalter $S_9$ geschlossen ist, verbindet er den invertierenden Eingang des Operationsverstärkers $A_2$ mit dem Speicherkondensator 41 im Zwischenspeicher 40. Der nichtinvertierende Eingang des Operationsverstärkers $A_2$ ist an Masse gelegt. Das Potential am invertierenden Eingang unterscheidet sich um die Offsetspannung $U_{02}$ des Operationsverstärkers $A_2$ von dem Massepotential des nichtinvertierenden Eingangs. Zwischen dem Ausgang des Operationsverstärkers $A_2$ und dem Bezugsleiter 30 erscheint die Ausgangsspannung $U_{A2}$.

Ein dem Integrator 42 nachgeschalteter Komparator 45 enthält einen Operationsverstärker $A_3$, der in be-

kannter Weise dadurch als Schwellenwertkomparator geschaltet ist, daß sein Rückkopplungskreis offen ist. Der invertierende Eingang des Operationsverstärkers $A_3$ ist mit dem Ausgang des Operationsverstärkers $A_2$ im Integrator 42 verbunden, und an den nichtinvertierenden Eingang des Operationsverstärkers $A_3$ ist gegenüber dem Bezugsleiter 30 eine Schwellenspannung $U_s$ angelegt. Zwischen den beiden Eingängen des Operationsverstärkers $A_3$ besteht die Offsetspannung $U_{03}$. Entsprechend der bekannten Funktion eines solchen Schwellenwertkomparators hat die Ausgangsspannung $U_{A3}$ des Operationsverstärkers $A_3$ einen niedrigen Wert, wenn die Spannung $U_{A2}$ über der Schwellenspannung $U_S$ liegt, und sie nimmt einen hohen Wert an, wenn die Spannung $U_{A2}$ die Schwellenspannung $U_S$ unterschreitet.

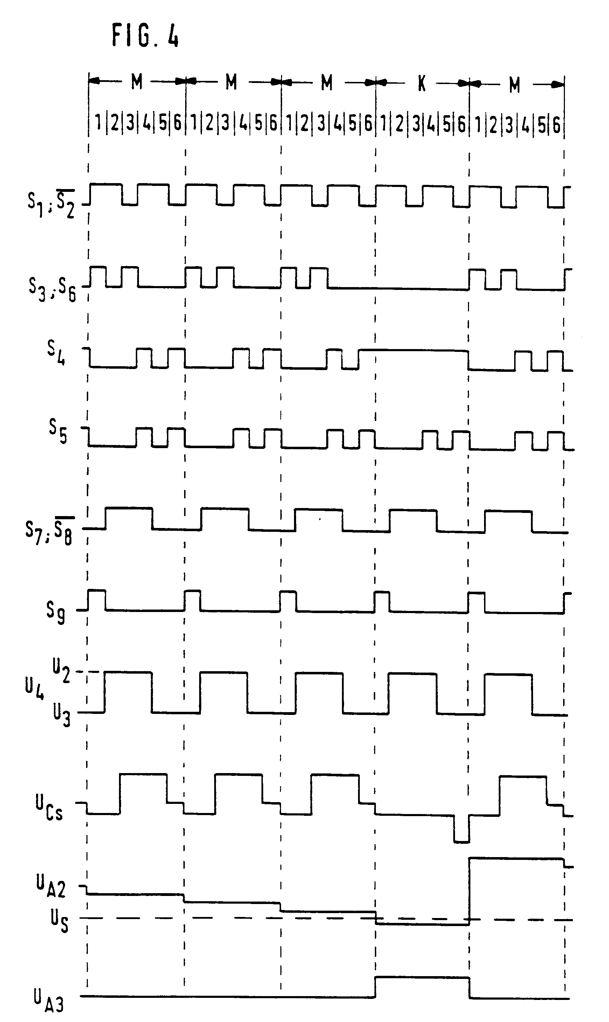

Die Schalter $S_1$ bis $S_9$ werden durch Steuersignale betätigt, die von einer Steuerschaltung 46 geliefert werden, die durch ein von einem Taktgeber 47 geliefertes Taktsignal synchronisiert wird. Zur Vereinfachung sind die Steuersignale mit den gleichen Bezugszeichen $S_1$, $S_2$ ... $S_9$ wie die von ihnen gesteuerten Schalter bezeichnet. Der zeitliche Verlauf der Steuersignale ist in den Diagrammen von Fig. 4 dargestellt. Jeder Schalter $S_1$, $S_2$ ... $S_9$ ist offen, wenn das ihn steuernde Signal den niedrigen Signalwert hat, und er ist geschlossen, wenn das ihn steuernde Signal den hohen Signalwert hat.

Die Schalter $S_1$, $S_2$ ... $S_9$ sind symbolisch als mechanische Schalterkontakte dargestellt, doch sind sie in Wirklichkeit natürlich durch schnelle elektronische Schalter, beispielsweise durch Feldeffekttransistoren gebildet.

Die Steuerschaltung 46 hat einen Steuereingang, der mit dem Ausgang des Operationsverstärkers $A_3$ im Komparator 45 verbunden ist. Ferner hat die Steuerschaltung 46 einen Ausgang, an den ein Meßzyklenzähler 48 angeschlossen ist, und einen weiteren Ausgang, an den ein Kompensationszyklenzähler 49 angeschlossen ist.

Die in Fig. 3 dargestellte Schaltung arbeitet nach dem Prinzip der Ladungsbalance. Gesteuert durch die Schalter $S_1$ bis $S_8$ werden in aufeinanderfolgenden Zyklen auf die Kondensatoren 21 und 22 des Sensors 20 Ladungspakete aufgebracht, die von den Spannungen $U_2$, $U_3$ und von den Kapazitäten $C_x$, $C_{ref}$ dieser Kondensatoren abhängen. Die maximale Größe der Ladungspakete innerhalb der Schaltung bei gegebenen Kapazitätswerten des Sensors 20 wird durch den Spannungsteiler 34 festgelegt. Die Ladungspakete werden im Speicherkondensator 41 zwischengespeichert und durch Schließen des Schalters $S_9$ auf den Integrationskondensator 43 übertragen, in dem sie aufsummiert werden. Die Spannung $U_{A2}$ entspricht der Spannung am Integrationskondensator 43, die wiederum von der auf dem Integrationskondensator integrierten Ladung abhängt. Der Ablauf der Schaltung wird so gesteuert, daß für $C_x > C_{ref}$ die Spannung $U_{A2}$ fortschreitend kleiner wird. Unterschreitet die Spannung $U_{A2}$ die vorgegebene Schwellenspannung $U_S$ des Komparators 45, so kippt dessen Ausgangsspannung $U_{A3}$ auf ihren maximalen Wert, wodurch die Steuerschaltung 46 zur Durchführung eines Kompensationszyklus veranlaßt wird. Im Kompensationszyklus werden die Schalter $S_1$ bis $S_8$ so gesteuert, daß beim nächsten Schließen des Schalters $S_9$ auf den Integrationskondensator 43 ein Kompensationsladungspaket, das im wesentlichen der Kapazität $C_{ref}$ des Referenzkondensators 22 proportional ist, mit solchem Vorzeichen übertragen wird, daß die Spannung $U_{A2}$ wieder über die Schwellenspannung $U_S$ angehoben wird. Dadurch findet im Integrationakondensator 43 eine Ladungsbalance statt, denn im zeitlichen Mittel ist die Summe aller integrierten Ladungspakete gleich Null. Dieses Gleichgewicht ist immer zu den Zeitpunkten vorhanden, in denen die Spannung $U_{A2}$ die Schwellenspannung $U_S$ des Komparators 45 unterschreitet.

Der Ablauf der zuvor allgemein beschriebenen Funktion soll nun anhand der Diagramme von Fig. 4 im einzelnen erläutert werden. Die Diagramme von Fig. 4 zeigen außer dem bereits erwähnten zeitlichen Verlauf der Schalter-Steuersignale $S_1$ bis $S_9$ auch den zeitlichen Verlauf der Spannungen $U_4$, $U_{A2}$ und $U_{A3}$ sowie der Spannung $U_{Cs}$ am Speicherkondensator 41 in mehreren Zyklen, von denen einer ein Kompensationszyklus K ist. Die anderen Zyklen, die keine Kompensationszyklen sind, werden als Meßzyklen M bezeichnet. Jeder Zyklus besteht aus sechs Phasen, die mit 1 bis 6 numeriert sind.

Die Schalter $S_1$ und $S_2$ werden durch ein periodisches Rechtecksignal im Gegentakt gesteuert, so daß der Schalter $S_1$ offen ist, wenn der Schalter $S_2$ geschlossen ist, und umgekehrt. In jedem Zyklus ist der Schalter $S_1$ während der Phasen 1-2 und 4-5 geschlossen und während der Phasen 3 und 6 offen. Wenn der Schalter $S_1$ geschlossen und der Schalter $S_2$ offen ist, können die im Eingangskreis des Operationsverstärkers $A_1$ liegenden Kondensatoren 21 und 22 des Sensors 20 durch die Schalter $S_3$ bzw. $S_5$ an die am invertierenden Eingang des Operationsverstärkers $A_1$ bestehende Spannung gelegt und entsprechend aufgeladen werden, ohne daß dadurch die Ladung im Speicherkondensator 41 beeinflußt wird. Dieser Zustand wird als "Konditionierphase" bezeichnet.

Die Schalter $S_7$ und $S_8$ werden ebenfalls durch ein periodisches Rechtecksignal im Gegentakt gesteuert, so daß der Schalter $S_7$ offen ist, wenn der Schalter $S_8$ geschlossen ist, und umgekehrt. Wenn der Schalter $S_7$ geschlossen und der Schalter $S_8$ offen ist, ist die Spannung $U_4$ gleich der Spannung $U_2$; wenn der Schalter $S_8$ geschlossen und der Schalter $S_7$ offen ist, ist die Spannung $U_4$ gleich der Spannung $U_3$. Dabei ist $U_2 > U_3$. Die Meß- und Kompensationsladungspakete werden im wesentlichen durch diese sprunghaften Änderungen der

Spannung $U_4$ erzeugt.

Der Schalter $S_6$ wird jeweils synchron mit dem Schalter $S_3$ betätigt, und der Schalter $S_4$ wird bis auf die Kompensationszyklen jeweils synchron mit dem Schalter $S_5$ betätigt. Die Schalter $S_4$ und $S_6$ haben die Aufgabe, die jeweils nicht aktive Signalleitung 27 bzw. 29 des Sensors 20 auf ein Potential zu legen, das sich nur um die Offsetspannung $U_{01}$ des Operationsverstärkers $A_1$ vom Potential der aktiven Signalleitung unterscheidet. Dadurch wird die Einkopplung von Fehlladungen über den jeweils inaktiven Sensor-Kondensator 21 bzw. 22 und dessen Signalleitung 27 bzw. 29 auf die aktive Signalleitung vermieden. Diese Funktion wird in der nachfolgenden Beschreibung vorausgesetzt; die jeweiligen Stellungen der Schalter $S_4$ und $S_6$ werden daher nicht gesondert erwähnt.

Nachfolgend wird der Zeitablauf des Betriebs der Signalverarbeitungsschaltung zunächst für einen Meßzyklus M und anschließend für einen Kompensationszyklus K beschrieben.

1. Meßzyklus M

Phase 1:

Am Beginn der Phase 1 jedes Meßzyklus M befindet sich auf dem Speicherkondensator noch die im vorhergehenden Zyklus aufgebrachte Ladung. Die Schalter $S_1$ und $S_9$ werden geschlossen, während gleichzeitig der Schalter $S_2$ geöffnet wird. Dadurch ist der Speicherkondensator vom Ausgang des Operationsverstärkers $A_1$ abgetrennt und mit dem Eingang des Integrators 42 verbunden, so daß eine Ladungsübertragung vom Speicherkondensator 41 auf den Integrationskondensator 43 stattfindet. Ferner ist in der Phase 1 der Schalter $S_7$ offen und der Schalter $S_8$ geschlossen, so daß die Spannung $U_4$ am nichtinvertierenden Eingang des Operationsverstärkers $A_1$ durch die Spannung $U_3$ gebildet wird. Nach der Entladung des Speicherkondensators 41 liegt am Speicherkondensator 41 die eingeprägte Spannung

$$U_{Cs} = U_{02} - U_3 - U_{01} \quad (1)$$

an. Somit befindet sich auf dem Speicherkondensator 41 die Restladung

$$Q_{Cs(R)} = (U_{02} - U_3 - U_{01}) \cdot C_s \quad (2)$$

Die Umlademenge fließt auf den Integrationskondensator 43. In allen weiteren Phasen 2 bis 5 jedes Zyklus ist der Schalter $S_9$ offen, so daß in diesen Phasen keine Umladung vom Speicherkondensator 41 auf den Integrationskondensator 43 stattfinden kann.

Ferner ist in der Phase 1 der Schalter $S_3$ geschlossen, so daß der Meßkondensator 21 mit dem invertierenden Eingang des Operationsverstärkers $A_1$ verbunden ist. Da zugleich der Schalter $S_1$ geschlossen und der Schalter $S_2$ offen ist, befindet sich die Schaltung in der Konditionierphase für den Meßkondensator 21. Der Meßkondensator 21 wird mit $U_4 = U_3$ auf die Ladung

$$Q_{Cx(1)} = (U_{01} + U_3 - U_1)\, Q_x \quad (3)$$

aufgeladen (konditioniert), ohne daß die Ladung auf dem Speicherkondensator 41 dadurch beeinflußt wird.

Phase 2:

In der Phase 2 wird der Schalter $S_3$ geöffnet, während der Schalter $S_5$ offen bleibt, so daß die beiden Kondensatoren 21 und 22 des Sensors 20 von den Eingängen des Operationsverstärkers $A_1$ abgetrennt sind. Zugleich wird der Schalter $S_7$ geschlossen und der Schalter $S_8$ geöffnet, so daß die Spannung $U_4$ vom Wert $U_3$ auf den Wert $U_2$ springt. Die parasitäre Kapazität $C_p$ wird entsprechend umgeladen. Da weiterhin der Schalter $S_1$ geschlossen und der Schalter $S_2$ offen ist, wird die gesamte Ladung, die zur Umladung der parasitären Kapazität $C_p$ erforderlich ist, vom Ausgang des Operationsverstärkers $A_1$ geliefert. Die Ladungen auf dem Speicherkondensator 41 und auf dem Integrationskondensator 43 bleiben von dieser Umladung unbeeinflußt.

Phase 3:

In der Phase 3 ist der Schalter $S_1$ offen und der Schalter $S_2$ geschlossen, so daß der Zwischenspeicher 40 bereit ist, Ladung auf den Speicherkondensator 41 zu übernehmen. Zugleich ist der Schalter $S_3$ wieder geschlossen, so daß der Meßkondensator 21 mit dem invertierenden Eingang des Operationsverstärkers $A_1$ verbunden ist und auf die Ladung

$$Q_{Cx(3)} = (U_{01} + U_2 - U_1)\, Q_x \quad (4)$$

umgeladen wird. Die Umlademenge

$$dQ_{Cx(3)} = Q_{Cx(3)} - Q_{Cx(1)} = (U_2 - U_3) \cdot C_x \quad (5)$$

fließt auf den Speicherkondensator 41.

EP 0 458 931 B1

**Phase 4:**

Die Phase 4 ist die Konditionierphase für den Referenzkondensator 22, da der Schalter $S_1$ geschlossen und der Schalter $S_2$ offen ist und zugleich der Schalter $S_5$ geschlossen ist, so daß der Referenzkondensator 22 mit dem invertierenden Eingang des Operationsverstärkers $A_1$ verbunden ist. Da weiterhin der Schalter $S_7$ geschlossen und der Schalter $S_8$ offen ist, hat die Spannung $U_4$ den Wert $U_2$. Somit wird der Referenzkondensator 22 auf die Ladung

$$Q_{Cref(4)} = (U_{01} + U_2 - U_1) \cdot C_{ref} \quad (6)$$

geladen (konditioniert), ohne daß die Ladung auf dem Speicherkondensator 41 davon beeinflußt wird.

**Phase 5:**

Der Schalter $S_5$ wird geöffnet, so daß der Referenzkondensator 22 vom invertierenden Eingang des Operationsverstärkers $A_1$ abgetrennt wird. Der Schalter $S_7$ wird geöffnet und der Schalter $S_8$ geschlossen, so daß die Spannung $U_4$ vom Wert $U_2$ auf den Wert $U_3$ springt und die parasitäre Kapazität $C_p$ entsprechend umgeladen wird. Da weiterhin der Schalter $S_1$ geschlossen und der Schalter $S_2$ offen ist, wird die gesamte Ladung, die zur Umladung der parasitären Kapazität $C_p$ erforderlich ist, vom Ausgang des Operationsverstärkers $A_1$ geliefert, ohne daß die Ladungen auf dem Speicherkondensator 41 und auf dem Integrationskondensator 43 davon beeinflußt werden.

**Phase 6:**

In der Phase 6 ist der Schalter $S_1$ offen und der Schalter $S_2$ geschlossen, so daß der Zwischenspeicher 40 bereit ist, Ladung auf den Speicherkondensator 41 zu übernehmen. Zugleich ist der Schalter $S_5$ wieder geschlossen, so daß der Referenzkondensator 22 mit dem invertierenden Eingang des Operationsverstärkers $A_1$ verbunden ist und auf die Ladung

$$Q_{Cref(6)} = (U_{01} + U_3 - U_1) \, Q_{ref} \quad (7)$$

umgeladen wird. Die Umlademenge

$$dQ_{Cref(6)} = Q_{Cref(6)} - Q_{Cref(4)} = -(U_2 - U_3) \cdot C_{ref} \quad (8)$$

fließt auf den Speicherkondensator 41.

Damit ist der Meßzyklus M beendet. Am Ende des Meßzyklus M enthält der Speicherkondensator 41 die resultierende Ladung

$$\begin{aligned} Q_{Cs} &= Q_{Cs(R)} + dQ_{Cx(3)} + dQ_{Cref(6)} \\ &= Q_{Cs(R)} + (U_2 - U_3) \cdot (C_x - C_{ref}) \end{aligned} \quad (9)$$

In der Phase 1 des folgenden Zyklus wird der Speicherkondensator 41 wieder auf die Restladung $Q_{Cs(R)}$ gemäß der Gleichung (2) entladen, wobei die Umlademenge

$$dQ_M = Q_{Cs(R)} - Q_{Cs} = -(U_2 - U_3) \cdot (C_x - C_{ref}) \quad (10)$$

auf den Integrationskondensator 43 übertragen wird. Die Umlademenge $dQ_M$ wird als Meßladungspaket bezeichnet. Mit $C_x > C_{ref}$ und $U_2 > U_3$ ist das Meßladungspaket $dQ_M$ negativ, so daß es einen negativen Spannungssprung in der Spannung $U_{A2}$ verursacht.

Die Phasen 1 bis 6 jedes Meßzyklus M werden zyklisch wiederholt, bis die Spannung $U_{A2}$ die Schwellenspannung $U_S$ des Komparators 45 unterschreitet und der Pegel der Spannung $U_{A3}$ von einem niedrigen auf einen hohen Wert geht. Dadurch wird die Steuerschaltung 46 zur Durchführung eines Kompensationszyklus K veranlaßt.

**2. Kompensationszyklus K**

Die Ablauffolge für einen Kompensationszyklus K ist mit der Ablauffolge der Meßzyklen M identisch, bis auf den Unterschied, daß der Schalter $S_3$ immer offen und der Schalter $S_4$ immer geschlossen bleibt. Dadurch fließt während des gesamten Kompensationszyklus K keine Ladung vom Meßkondensator 22 in den Speicherkondensator 41. Demzufolge gilt anstelle der Gleichung (5):

$$dQ_{Cx(3)} = 0 \quad (11)$$

Setzt man die Gleichungen (11) und (8) in die Gleichung (9) ein, so erhält man als resultierende Ladung im Speicherkondensator 41 am Ende des Kompensationszyklus K:

7

$$Q_{Cs} = Q_{Cs(R)} + dQ_{Cx(3)} + dQ_{Cref(6)}$$
$$= Q_{Cs(R)} - (U_2 - U_3) \cdot C_{ref} \qquad (12)$$

In der Phase 1 des folgenden Zyklus wird der Speicherkondensator 41 wieder auf die Restladung $Q_{Cs(R)}$ gemäß der Gleichung (2) entladen, wobei die Umlademenge

$$dQ_K = Q_{Cs(R)} - Q_{Cs} = + (U_2 - U_3) \cdot C_{ref} \qquad (13)$$

auf den Integrationskondensator 43 übertragen wird. Die Umlademenge $dQ_K$ wird als Kompensationsladungspaket bezeichnet. Mit $U_2 > U_3$ ist das Kompensationsladungspaket $dQ_K$ positiv, so daß es einen positiven Spannungssprung in der Spannung $U_{A2}$ verursacht. Der positive Spannungssprung hat zur Folge, daß die Spannung $U_{A2}$ wieder über die Schwellenspannung $U_S$ angehoben wird, so daß der Pegel der Spannung $U_{A3}$ wieder von dem hohen Wert auf den niedrigen Wert geht. Dadurch wird die Steuerschaltung 46 wieder zur Durchführung von Meßzyklen M veranlaßt, und der Kompensationszyklus K ist abgeschlossen.

Ladungsbalance

Durch die Gleichungen (10) und (13) sind die Meßladungspakete $dQ_M$ bzw. die Kompensationsladungspakete $dQ_K$ beschrieben. Das Meßverfahren arbeitet nach der Methode der Ladungsbalance, d.h. es stellt sich ein Ladungsgleichgewicht im Integrationskondensator 43 ein. Das Ladungsgleichgewicht ist im zeitlichen Mittel immer zu den Zeitpunkten der Unterschreitung der Schwellenspannung $U_S$ vorhanden. Betrachtet man den Ladungszustand des Integrationskondensators 43, so wird eine bestimmte Anzahl von Meßladungspaketen $dQ_M$ integriert, bis die Schwellenspannung $U_S$ unterschritten wird; dann werden die integrierten Meßladungspakete durch ein Kompensationsladungspaket $dQ_K$ kompensiert, und der Vorgang beginnt von neuem.

Die Steuerschaltung 46 liefert bei jeder Durchführung eines Meßzyklus M einen Impuls zu dem Zähleingang des Meßzyklenzählers 48 und bei jeder Durchführung eines Kompensationszyklus einen Impuls zu dem Zähleingang des Kompensationszyklenzählers 49. Betrachtet man ein Zeitintervall, in dem der Meßzyklenzähler 48 insgesamt n Meßzyklen M und der Kompensationszyklenzähler 49 insgesamt k Kompensationszyklen K gezählt hat, so muß infolge der Ladungsbalance gelten:

$$n \cdot dQ_M + k \cdot dQ_K = 0 \qquad (14)$$
$$- n \cdot (U_2 - U_3) \cdot (C_x - C_{ref}) + k \cdot (U_2 - U_3) \cdot C_{ref} = 0 \qquad (15)$$

Man erhält somit das gesuchte Kapazitätsverhältnis unmittelbar aus dem Verhältnis der in dem betrachteten Zeitintervall in den Zählern 48 und 49 gezählten Impulse:

$$\frac{k}{n} = \frac{C_x - C_{ref}}{C_{ref}} \qquad (16)$$

Das gleiche Ergebnis erhält man, wenn man das Verhältnis der Folgefrequenzen der den beiden Zählern 48 und 49 zugeführten Impulsfolgen bildet.

Die Kapazitätswerte der Kondensatoren 41 und 43, die Offsetspannungen der Operationsverstärker, das Bezugspotential $U_1$ des Sensors 20, die Betriebsspannung der Schaltung und die Frequenz, mit der die Steuerschaltung 46 getaktet wird, gehen, wie aus der Gleichung (16) zu ersehen ist, nicht in das Meßergebnis ein.

Der Wert der Spannung $U_1$ wird nur durch den Arbeitsbereich der Schaltung begrenzt.

In Fig. 3 sind die Abschirmungen der Signalleitungen 27 und 29 mit der von der Schaltergruppe 33 zum nichtinvertierenden Eingang des Operationsverstärkers $A_1$ führenden Leitung verbunden. Das Potential der Abschirmungen ist daher dem sich ändernden Bezugspotential des Eingangsoperationsverstärkers nachgeführt und entspricht somit im wesentlichen stets dem Potential der abgeschirmten Leiter. Auch diese Maßnahme trägt dazu bei, die Einkopplung von Fehlladungen auf die aktive Signalleitung zu vermeiden.

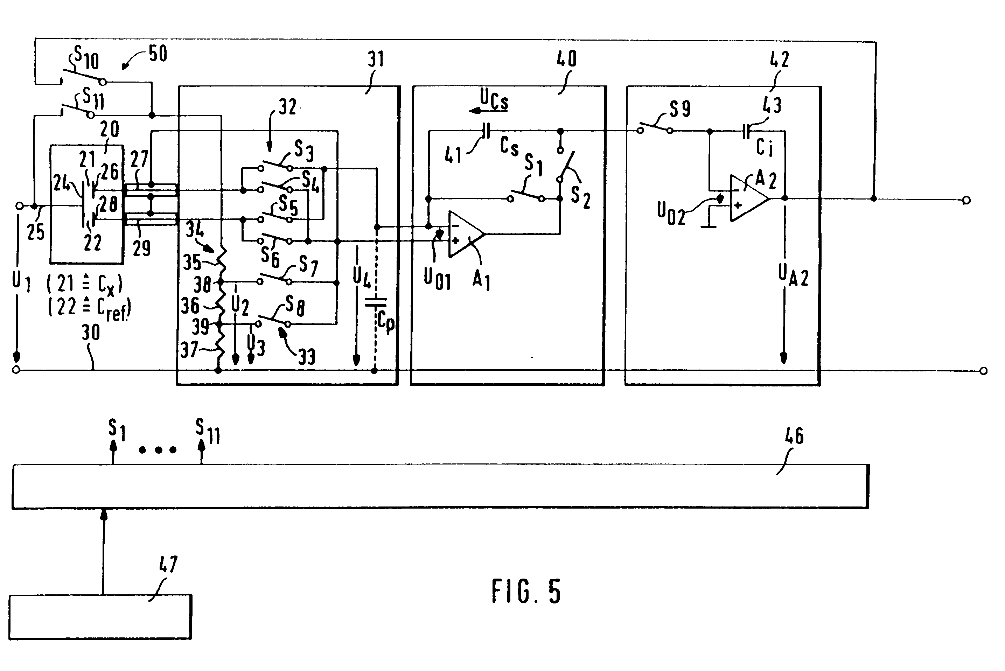

Fig. 5 zeigt ein zweites Ausführungsbeispiel der Signalverarbeitungsschaltung 2 von Fig. 1 für die Signalaufbereitung des vom kapazitiven Sensor 20 gelieferten Sensorsignals. Die Signalverarbeitungsschaltung der Fig. 5 unterscheidet sich von derjenigen der Fig. 3 zunächst dadurch, daß deren Komparator 45 sowie die beiden Zähler 48, 49 fehlen, die anderen Teilschaltungen und Bauelemente jedoch beibehalten sind, die auch dieselben Bezugszeichen wie in Fig. 3 tragen. Ein weiterer Unterschied besteht im Vorhandensein einer dritten Schaltergruppe 50 aus Schaltern $S_{10}$, $S_{11}$.

Das nicht am Bezugsleiter 30 liegende Ende des Spannungsteilers 34 ist entweder über den Schalter $S_{10}$ mit dem Ausgang des Integrators 42 oder über den Schalter $S_{11}$ mit dem Anschlußleiter 25 verbunden. Die beiden Schalter $S_{10}$, $S_{11}$, deren Steuersignale die Steuerschaltung 46 ebenfalls erzeugt, sind niemals gleichzeitig geschlossen. Ferner sind sie - wie die Schalter $S_1...S_9$ - offen, wenn das Steuersignal den niedrigen Signalwert hat, und geschlossen, wenn es den hohen Signalwert hat. Auch sind ihre Steuersignale mit denselben Bezugs-

zeichen $S_{10}$, $S_{11}$ versehen, und sie sind, wie oben bereits erwähnt, mittels schneller elektronischer Schalter realisiert.

Die Schaltung der Fig. 5 arbeitet ebenso wie die der Fig. 3 nach dem Prinzip der Ladungsbalance. Wiederum gesteuert durch die Schalter $S_1...S_8$ werden in aufeinanderfolgenden Zyklen auf die Kondensatoren 21, 22 des Sensors 20 Ladungspakete aufgebracht, die von den Spannungen $U_2$, $U_3$ und von den Kapazitäten $C_x$, $C_{ref}$ dieser Kondensatoren abhängen. Die maximale Größe der Ladungspakete innerhalb der Schaltung bei gegebenen Kapazitätswerten des Sensors 20 wird durch den Spannungsteiler 34 festgelegt. Die Ladungspakete werden im Speicherkondensator 41 zwischengespeichert und durch Schließen des Schalters $S_9$ auf den Integrationskondensator 43 übertragen, in dem sie aufsummiert werden. Die Spannung $U_{A2}$ entspricht der Spannung am Integrationskondensator 43, die wiederum von der darauf integrierten Ladung abhängt.

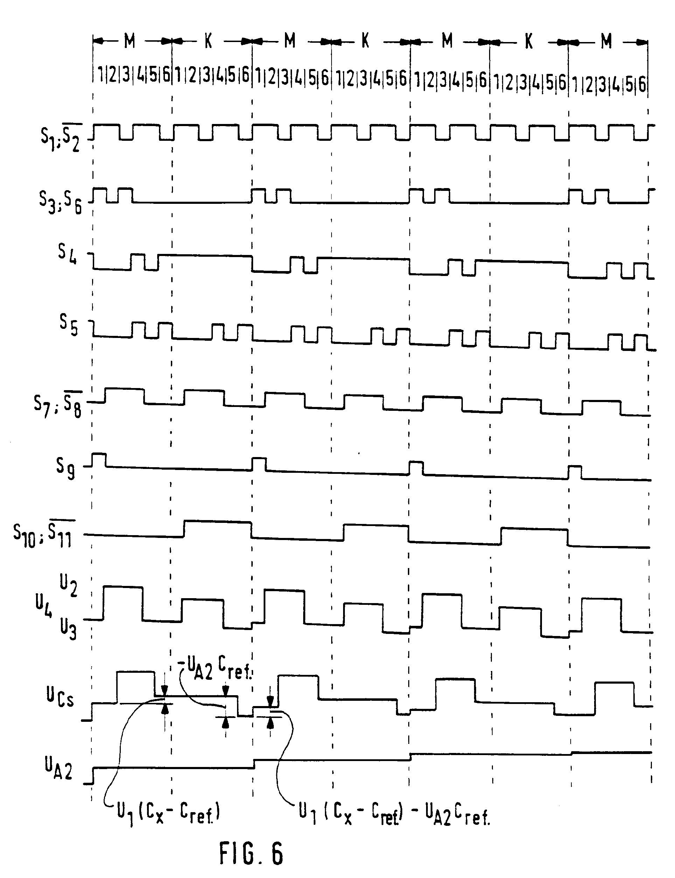

Der Ablauf der eben allgemein beschriebenen Funktion der Fig. 5 soll nun anhand der Diagramme der Fig. 6 im einzelnen nur insoweit noch erläutert werden, als sie von der Funktion der Fig. 3 und deren Diagrammen nach Fig. 4 abweicht. Die Fig. 6 zeigt außer dem zeitlichen Verlauf der Schalter-Steuersignale $S_1...S_{11}$ auch den der Spannungen $U_4$, $U_{A2}$ und den der Spannung $U_{Cs}$ am Speicherkondensator 41 in mehreren Zyklen, von denen jeder zweite ein Kompensationszyklus K ist. Die anderen Zyklen, die keine Kompensationszyklen sind, sind wieder als Meßzyklen M bezeichnet. Die abwechselnde Reihenfolge der beiden Arten von Zyklen in Fig. 6 ist nur beispielhaft; es kann vielmehr eine beliebige Anzahl von Kompensationszyklen auf eine beliebige Anzahl von Meßzyklen folgen. Jeder Zyklus besteht wieder aus sechs Phasen, die wieder mit 1 bis 6 numeriert sind.

Die Steuerung der Schalter $S_1...S_8$ und die dadurch erzeugten Funktionen sind identisch mit denen der Schalter $S_1...S_8$ von Fig. 3. Im Gegensatz zu Fig. 3 bleibt der Schalter $S_9$ während jedes Kompensationszyklus K offen, so daß auf den Integrationskondensator 43 nur während jeweils Phase 1 der Meßzyklen M Ladung übertragen wird.

Ferner ist Schalter $S_{11}$ während der Meßzyklen M und während der Phase 1 der Kompensationszyklen K geschlossen, in welchen Zeiten Schalter $S_{10}$ offen ist. Somit liegt zu diesen Zeiten das nicht am Bezugsleiter 30 liegende Ende des Spannungsteilers 34 am Anschlußleiter 25 und damit an der festen Spannung $U_1$.

In dieser Phase gilt:

$$U_2 - U_3 = U_1 \cdot R_{36}/(R_{35} + R_{36} + R_{37}) = U_1 \cdot v_R \quad (17)$$

In den Phasen 2 bis 6 der Kompensationszyklen K ist Schalter $S_{11}$ dagegen offen und Schalter $S_{10}$ geschlossen, so daß der Spannungsteiler 34 mit dem Ausgang des Integrators 42 verbunden ist und damit am Spannungsteiler 34 die analoge Ausgangsspannung $U_{A2}$ des Operationsverstärker $A_2$ liegt.

In diesen Phasen gilt:

$$U_2 - U_3 = U_{A2} \cdot R_{36}/(R_{35} + R_{36} + R_{37}) = U_{A2} \cdot v_R \quad (18)$$

In den Gleichungen (17), (18) ist mit $R_{35}$, $R_{36}$, $R_{37}$ der jeweilige Widerstandswert der Widerstände 35, 36, 37 des Spannungsteilers 34 bezeichnet.

Die für die beliebigen Anzahlen n, k von Zyklen gültigen Gleichungen (15), (16) nehmen daher folgende Form an:

$$- n \cdot U_1 \cdot v_R \cdot (C_x - C_{ref}) + k \cdot U_{A2} \cdot v_R \cdot C_{ref} = 0 \quad (19)$$

$$(k/n) \cdot (U_{A2}/U_1) = (C_x - C_{ref})/C_{ref} \quad (20)$$

**Patentansprüche**

1. Anordnung zur Verarbeitung von Sensorsignalen, die von einem kapazitiven Sensor (1, 10, 20) geliefert werden, der einen Meßkondensator (21) mit von einer zu erfassenden physikalischen Meßgröße beeinflußbarer Meßkapazität ($C_x$) und mindestens einen Referenzkondensator (22) mit in anderer Weise beeinflußbarer Referenzkapazität ($C_{ref}$) enthält und einen von diesen beiden abhängigen Meßeffekt (M) liefert, mit einer nach dem Prinzip des quantisierten Ladungstransports mittels Schalter-Kondensator-Strukturen und Ladungsbalance mindestens im zeitlichen Mittel arbeitenden Signalverarbeitungsschaltung (2), die die den Meßeffekt (M) darstellenden Sensorsignale empfängt und ein ihm entsprechendes Ausgangssignal ($S/S_{ref}$) liefert, von welchen Kondensatoren (21, 22) erste Elektroden (14; 24) auf einem festen Potential ($U_1$) liegen und zweite Elektroden (16, 18; 26, 28) zur Durchführung des Ladungstransports mit dem ersten Eingang eines Eingangsoperationsverstärkers ($A_1$) verbindbar sind, dessen zweiter Eingang auf einem Bezugspotential ($U_4$) liegt, das zwecks der zur Bildung der transportierten Ladungspakete erforderlichen Umladung der Kondensatoren (21, 22) umgeschaltet wird.

2. Anordnung nach Anspruch 1, bei der die zweite Elektrode (26, 28) des jeweils nicht zur Durchführung des Ladungstransports mit dem Eingangsoperationsverstärker ($A_1$) verbundenen Kondensators auf dessen

Bezugspotentialt ($U_4$) geschaltet ist.

3. Anordnung nach Anspruch 1 oder 2, bei der zur Eliminierung einer in der zum ersten Eingang des Eingangsoperationsverstärkers ($A_1$) führenden Verbindung vorhandenen parasitären Kapazität ($C_p$) die Kondensatoren (21, 22) während der Umschaltung des Bezugspotentials ($U_4$) vom Eingangsoperationsverstärker abgetrennt sind.

4. Anordnung nach einem der Ansprüche 1 bis 3, bei der zwischen dem Sensor (1, 10, 20) und den Eingangsoperationsverstärker ($A_1$) ein Funktionsblock (31) eingefügt ist, der eine erste Gruppe (32) von periodisch betätigten Schaltern ($S_3...S_6$) enthält, die die zweiten Elektroden (26,28) der Kondensatoren (21, 22) wahlweise mit dem ersten Eingang des Eingangsoperationsverstärkers ($A_1$) verbinden bzw. an dessen Bezugspotential ($U_4$) legen, und bei der der Funktionsblock (31) eine zweite Gruppe (33) von periodisch betätigten Schaltern ($S_7...S_8$) enthält, die abwechselnd die eine oder die andere von zwei Spannungen ($U_2$, $U_3$) zur Umschaltung des Bezugspotentials ($U_4$) an den zweiten Eingang des Eingangsoperationsverstärkers ($A_1$) legen.

5. Anordnung nach einem der Ansprüche 1 bis 4, bei der die von den Elektroden (26, 28) zu den Eingängen des Eingangsoperationsverstärkers ($A_1$) führenden Signalleitungen (27, 29) abgeschirmt sind und deren Potential dem Bezugspotential (U4) des Eingangsoperationsverstärkers ($A_1$) nachgeführt ist.

6. Anordnung nach einem der Ansprüche 1 bis 5, bei der der Funktionsblock (31) einen Spannungsteiler (34) enthält, an dem die zur Bildung der Meßladungspakete dienenden Spannungen ($U_2$, $U_3$) abgegriffen sind und der zur Anpassung der Meßladungspakete an den Betriebsbereich der Signalverarbeitungsschaltung (2) eingestellt ist.

7. Anordnung nach einem der Ansprüche 1 bis 6 mit analogem Ausgangssignal ($U_{A2}$), bei der das nicht mit dem Bezugsleiter (30) liegende Ende des Spannungsteilers (34) entweder über den einen Schalter ($S_{10}$) einer dritten Schaltergruppe (50) zur Bildung der Kompensationsladungspakete mit dem Ausgang des Integrators (42) oder über den anderen Schalter ($S_{11}$) der Schaltergruppe (50) zur Bildung der Meßladungspakete mit dem festen Potential ($U_1$) verbindbar sind.

## Claims

1. Arrangement for processing sensor signals furnished by a capacitive sensor (1, 10, 20 ) which includes a measuring capacitor (21) having a measuring capacitance ($C_x$) influenceable by a physical measured quantity to be determined and at least one reference capacitor (22) having a reference capacitance ($C_{ref}$) influenceable in another manner and furnishing a measuring effect (M) dependent on said measuring capacitance and said reference capacitance, comprising a signal processing circuit (2) which operates by the principle of quantized charge transport by means of switch-capacitor structures and charge balancing at least in time average and which receives said sensor signals representing said measuring effect and furnishes an output signal ($S/S_{ref}$) corresponding to said measuring effect, wherein first electrodes (14; 24) of said capacitors (21, 22) of said sensor lie at a fixed potential ($U_1$) and second electrodes of them for performing said charge transport are connectable to a first input of an input operational amplifier ($A_1$), a second input of which lies at a reference potential ($U_4$), and wherein a reverse charging of said capacitors (21, 22) of said sensor necessary for forming transported charge packets is effected by switching over said reference potential of said input operational amplifier.

2. Arrangement according to claim 1, wherein said second electrode (26, 28) of that particular capacitor not connected to one of said inputs of said input operational amplifier ($A_1$) for performing said charge transport is switched to said reference potential ($U_4$) of said input operational amplifier.

3. Arrangement according to claim 1 or 2, wherein to eliminate a parasitic capacitance ($C_p$) in a connection leading to said first input of said input operational amplifier ($A_1$), said capacitors (21, 22) of said sensor are separated from said input operational amplifier during the switching over of said reference potential ($U_4$).

4. Arrangement according to claim 1, wherein between said sensor (1, 10, 20) and said input operational amplifier ($A_1$) a function block (31) is inserted which contains a first group (32) of periodically actuated

switches ($S_3$ ... $S_6$) which selectively connect said second electrodes (26, 28) of said capacitors (21, 22) to said first input of said input operational amplifier ($A_1$) or to said reference potential ($U_4$) of said input operational amplifier, and said function block (31) includes a second group (33) of periodically actuated switches ($S_7$ ... $S_8$) which alternately apply a first or a second voltage ($U_2$, $U_3$) to said second input of said input operational amplifier for switching said reference potential ($U_4$) over.

5. Arrangement according to claim 1, wherein signal lines (27, 29) leading from said electrodes (26, 28) of said sensor capacitors to said inputs of said input operational amplifier ($A_1$) are shielded and the potential of shields of said signal lines is caused to follow up said reference potential ($U_4$) of said input operational amplifier ($A_1$).

6. Arrangement according to claim 4, wherein said function block (31) contains a voltage divider (34) at which said voltages ($U_2$, $U_3$) serving for generating said measuring charge packets are tapped and which is adjusted for matching said measuring charge packets to a working range of said signal processing circuit (2).

7. Arrangement according to claim 6 delivering an analog output signal ($U_{A2}$), wherein either for generating said compensation charge packets a terminal of said voltage divider (34) not facing a reference conductor (30) is connectable via a first switch ($S_{10}$) of a third group (50) of switches to the output of an integrator (42) or for generating said measuring charge packets said terminal is connectable via a second switch ($S_{11}$) of said third group (50) of switches to said fixed potential ($U_1$).

## Revendications

1. Dispositif de traitement de signaux de capteurs qui sont fournis par un capteur capacitif (1, 10, 20) qui comprend un condensateur de mesure (21) possédant une capacité de mesure ($C_x$) qui peut être influencée par une grandeur de mesure physique à capter, et au moins un condensateur de référence (22) possédant une capacité de référence ($C_{ref}$) qui peut être influencée d'une autre façon, et qui délivre un effet de mesure (M) fonction de ces deux capacités, ce dispositif comprenant un circuit (2) de traitement des signaux qui travaille selon le principe du transport de charges quantifié, au moins en moyenne temporelle, au moyen de structures interrupteur-condensateur et d'une balance de charges, qui reçoit les signaux de capteurs représentant l'effet de mesure (M) et délivre un signal de sortie ($S/S_{ref}$) qui lui correspond, des premières électrodes (14 ; 24) de ces condensateurs (21, 22) étant à un potentiel fixe ($U_1$) et des deuxièmes électrodes (16, 18 ; 26, 28) pouvant être connectées, pour l'exécution du transport de charges, à la première entrée d'un amplificateur opérationnel d'entrée ($A_1$) dont la deuxième entrée est à un potentiel de référence ($U_4$) qui est inversé pour l'inversion de charge des condensateurs (21, 22) nécessaire pour la formation des paquets de charges transportés.

2. Dispositif selon la revendication 1, dans lequel la deuxième électrode (26, 28) du condensateur qui n'est pas connecté à l'amplificateur opérationnel d'entrée ($A_1$) pour l'exécution du transport de charges est commutée au potentiel de référence ($U_4$) de celui-ci.

3. Dispositif selon la revendication 1 ou 2, dans lequel, pour l'élimination d'une capacité parasite ($C_p$) qui est présente dans la liaison menant à la première entrée de l'amplificateur opérationnel d'entrée ($A_1$), les condensateurs (21, 22) sont isolés de l'amplificateur opérationnel d'entrée pendant l'inversion du potentiel de référence ($U_4$).

4. Dispositif selon une des revendications 1 à 3, dans lequel est intercalé, entre le capteur (1, 10, 20) et l'amplificateur opérationnel d'entrée ($A_1$), un bloc fonctionnel (31) qui renferme un premier groupe (32) d'interrupteurs ($S_3$...$S_6$) actionnés périodiquement, qui connectent sélectivement les deuxièmes électrodes (26, 28) des condensateurs (21, 22) à la première entrée de l'amplificateur opérationnel d'entrée ($A_1$) ou les mettent au potentiel de référence ($U_4$) de celui-ci, et dans lequel le bloc fonctionnel (31) comprend un deuxième groupe (33) d'interrupteurs ($S_7$...$S_8$) actionnés périodiquement, qui appliquent alternativement l'une ou l'autre de deux tensions ($U_2$, $U_3$) à la deuxième entrée de l'amplificateur opérationnel d'entrée ($A_1$) pour l'inversion du potentiel de référence ($U_4$).

5. Dispositif selon une des revendications 1 à 4, dans lequel les lignes de signaux (27, 29) qui mènent des électrodes (26, 28) aux entrées de l'amplificateur opérationnel d'entrée ($A_1$) sont blindées et leur potentiel suit le potentiel de référence ($U_4$) de l'amplificateur opérationnel d'entrée ($A_1$).

6. Dispositif selon une des revendications 1 à 5, dans lequel le bloc fonctionnel (31) renferme un diviseur de tension (34) sur lequel sont prises les tensions ($U_2$, $U_3$) servant à la formation des paquets de charges de mesure, et qui est réglé pourl'adaptation des paquets de charges de mesure au domaine de travail du circuit (2) de traitement des signaux.

7. Dispositif selon une des revendications 1 à 6, donnant un signal de sortie analogique ($U_{A2}$), dans lequel l'extrémité du diviseur de tension (34) qui n'est pas connectée à la ligne de référence (30) peut être connectée, soit à la sortie de l'intégrateur (42) à travers le premier interrupteur ($S_{10}$) d'un troisième groupe d'interrupteurs (50) pour la formation des paquets de charges de compensation, soit au potentiel fixe ($U_1$), à travers l'autre interrupteur ($S_{11}$) du groupe d'interrupteurs (50), pour la formation des paquets de charges de mesure.

FIG.1

FIG.2

FIG.3

EP 0 458 931 B1

# FIG. 4

FIG. 5

EP 0 458 931 B1

FIG. 6

17